# EUROPEAN PATENT APPLICATION

(11) **EP 2 927 805 A1**
(43) Date of publication of application: **07.10.2015**
(21) Application number: 14162949.3
(22) Date of filing: 31.03.2014
(51) Int. Cl.: G06F 7/60, G06J 1/00

(54) **Control system**

(71) Applicant: NXP B.V., 5656 AG Eindhoven (NL)
(72) Inventor: de Greef,, Petrus, Redhill, Surrey RH1 1SH (GB)
(74) Representative: Hardingham, Christopher Mark

(57) **Abstract**

The disclosure relates to a control system comprising: one or more converters, each configured to receive an analog input signal and provide a pulse density modulated signal in accordance with the respective input signal, wherein the one or more converters are configured to operate at the same clock rate; an arithmetic unit configured to perform an arithmetic function on the one or more pulse density modulated signals and provide a modified pulse density modulated signal; and a control unit configured to receive the modified pulse density modulated signal and provide a control signal in accordance with the modified pulse density modulated signal.

## Description

The invention relates to a control system. In particular, although not exclusively, the invention relates to a control system for a power converter such as a switched mode power supply.

Power converters typically use components like diodes, rectifiers, inductors, capacitors, transformers and power switches to convert a mains AC source power into a stable DC supply voltage. An objective of the converter is to control the power switches such that efficiency and safety of the system are optimised.

Power converters can accurately control their output voltage and/or current because they have an embedded feedback loop which actively corrects for power variations in the source and/or load. A control system that provides a proportional and integrating (PI) control process with optimal adjusted coefficients can provide an accurate and stable power conversion process. Typically an integrated circuit is used to provide a control system and controls the feedback loop of a converter, such as a fly-back converter, by driving power switches of the converter in an accurately controlled way. Such control circuits may be implemented using analogue electronics.

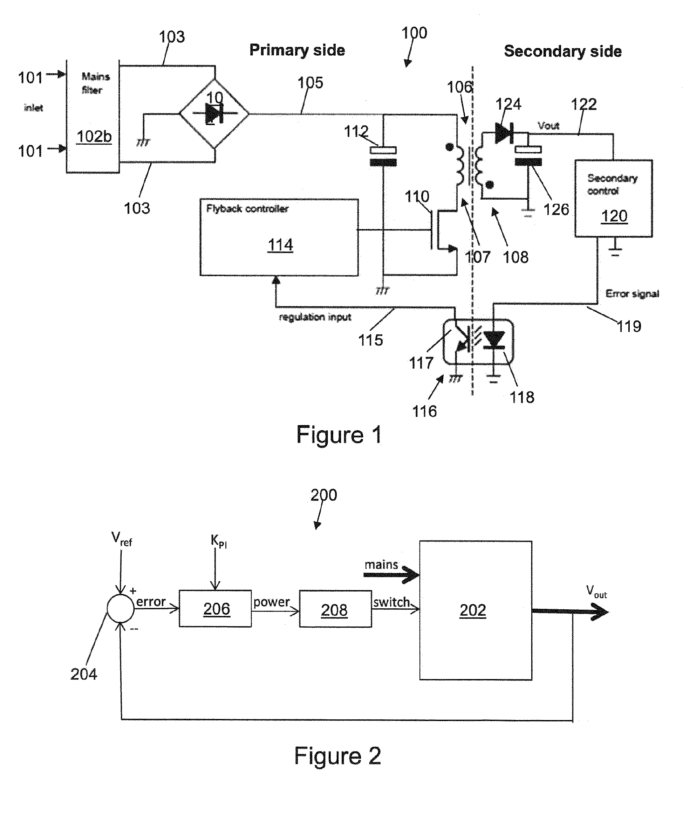

Figure 1 illustrates a switched mode power supply (SMPS) 100 comprising a transformer 106 with a primary winding 107 and a secondary winding 108. The SMPS 100 has a control system comprising a secondary side controller 120 that communicates with a primary side flyback controller 114 via an opto-coupler 116. The control system of the SMPS 100 is configured to regulate a current or voltage by sensing an output signal 122, compare the output signal 122 with a reference value at the secondary side of a transformer 106 to determine a difference/error signal 119 and send the error signal 119 from the secondary side to the primary side via the opto-coupler 116. At the primary side, the fly-back controller regulates operation of the transformer in accordance with the error signal 119.

An AC power supply signal 101 is provided to a mains filter 102b, which prevents high frequency noise produced by the switching actions inside the converter from reaching the power supply signal 101. The converter power signal 103 is provided to a bridge rectifier 104 which in this example provides full wave rectification of the converter power signal 103. A rectified signal 105 is provided by the bridge rectifier 104 to a first terminal of the primary winding 107 of the transformer 106. A second terminal of the primary winding 107 of the transformer 106 is coupled to primary ground via the conduction channel of a power switch. In this example, the switch is provided as a field effect transistor 110 with the conduction channel being the source-drain path of the transistor 110. The first terminal of the primary winding 107 is also coupled to primary ground by a capacitor 112. The effect of this capacitor 112 is to smooth the rectified signal 105 supplied by the AC power supply 101.

On the secondary side of the transformer 106, the secondary winding 108 is coupled in series with a rectifier, which in this example is a diode 124. An output capacitor 126 is provided in parallel with the series arrangement of the secondary winding 108 and the diode 124. The output capacitor 126 is configured to store charge in order to smooth the output voltage. The output capacitor 126 may be selected to have a suitably large capacitance such that a ripple voltage in the output signal 122 falls below the maximum allowed for the system.

A first terminal of the secondary winding 108 is coupled to a terminal of an output diode 124 that is configured to allow conventional current to flow away from the first terminal of the secondary winding 108. The second terminal of the output diode 124 is coupled to a first plate of an output capacitor 126 (this output capacitor can also be referred to as an elcap). The second plate of the output capacitor 126 is coupled to both a second terminal of the secondary winding 108 and the electrically isolated secondary ground. The output signal 122 is provided at the junction between the output diode 124 and the output capacitor 126.

A secondary side controller 120 receives the output signal 122 of the flyback converter from the secondary winding 108 and determines an error signal 119. The error signal 119 may be a signal that provides information necessary to control the primary winding 107 or may purely be indicative of the divergence in the output signal 122 from a desired value.

The opto-coupler 116 has a secondary side emitter 118 and a primary side sensor 117 which are electrically isolated from one another. The secondary side emitter 118 is connected to the secondary controller 120 in order to receive the error signal 119 and transmit the error signal to the primary side sensor 117. The primary side sensor 117 provides a regulation input signal 115, which relates to the error signal 119, to a flyback controller 114. The flyback controller 114 controls the gate of the power switch 110 in order to vary the gate potential in accordance with the regulation input signal 115 received from the opto-coupler 116.

Such a system may be implemented with analogue electronics and, except for the power-switch, the system has a continuous-time behaviour. As such, the error signal 119 is typically an analogue signal.

However, it is envisaged that providing a digital implementation of a controller for a power converter circuit could reduce cost and increase its performance, as well as enable digital signal processing functionality within the control system. Unfortunately, the discrete time nature of a digital system may introduce large propagation delays. In a control loop, an increase in propagation delay negatively impacts the stability of the system. A power controller for a power converter would require a plurality of analogue-to-digital and digital-to-analogue converters in order to digitize the control system, and each of these converters introduce extra latency into the feedback loop. One of the main problems when converting from an analogue to a digital implementation is that the extra latency is introduced into the control loop. This has a negative impact on the stability of the power conversion system. Other required functionality in the control loop may also introduce some latency, like e.g. a low-pass filter. Yet, this latency is independent of the used analogue or digital implementation. The main source of the additional propagation delay is the discrete-time nature of conventional digital systems. This introduces a propagation delay of at least half the sample-rate of the involved signals. When the sample-rate comes close to the system bandwidth the system is instable. Increasing the sample rate to a higher frequency can make the system stable, yet requires extra processing power.

This relative disadvantage of providing a digitally implemented control system should be addressed in order that the advantages of digital signal processing can be attained.

In accordance with a first aspect of the invention there is provided a control system comprising:
one or more converters, each configured to receive an analog input signal and provide a pulse density modulated signal in accordance with the respective input signal, wherein the one or more converters are configured to operate at the same clock rate;
an arithmetic unit configured to perform an arithmetic function on the one or more pulse density modulated signals and provide a modified pulse density modulated signal; and
a control unit configured to receive the modified pulse density modulated signal and provide a control signal in accordance with the modified pulse density modulated signal.

The control system provides low latency analogue-to-digital converter (ADC), digital-to-analogue converter (DAC) as well as providing low latency digital signal processing (DSP) and therefore provides a solution to the above problems of how to provide a digital control system suitable for use in a power converter. Low latency digital signal processing enables the use of advanced and non-linear digital signal processing algorithms to be applied in timing-critical control loops, like the fly-back control loop in a power converter system. This solution can be applied to any digital controlled feedback loop, hence the invention can be applied in a very broad range of applications.

Signal decimation is not necessarily required in such a control system. In addition, digital signal processing is performed in the pulse density modulated (PDM) domain and so the functional behavior of the control system can resemble that of a continuous-time (analog) circuit. That is, the control system provides digital signal processing in the pulse density modulated domain and so reduces latency compared to multi-bit digital processing, without introducing extra circuit complexity.

Advantage of using density arithmetic in the arithmetic unit are:
1. the PDM signal has time-continuous nature (avoid timing latencies)
2. that it allows 1-bit digital processing (simplicity)
3. that efficient known convertors between the analog/PDM domains are available (simplicity)

The one or more converters may each comprise a sigma delta converter.

The arithmetic unit may be configured to perform an arithmetic function on the one or more pulse density modulated signals and one or more multi-bit values. A multi-bit signal or value may comprise a multi-bit machine word, such as a binary word. The one or more multi-bit values are stored in a parameter register.

The arithmetic unit may comprise an adder unit. The adder unit may have a plurality of inputs, a carry bit output and a remainder output. The arithmetic unit may comprise a register configured to receive a remainder from the adder unit in a first clock cycle and provide the received remainder as one of the plurality of inputs to the adder unit in a subsequent clock cycle. The control unit may be configured to provide the control signal in accordance with a pulse density modulated signal at the carry bit output of the adder unit. The adder unit may be configured to add together signals at the plurality of inputs and provide a signal at the carry bit output if the signals at the plurality of inputs are greater than a weighting value and provide a remainder signal at the remainder output that is equal to the sum of the added together signals at the plurality of inputs divided by the weighting value, minus a value of the signal at the carry bit output. The weighting value may relate to the number of inputs that the adder unit has. The weighting value may relate to a weight of one or more of the plurality of inputs.

One or more of the inputs of the adder unit may be configured to receive one or more respective pulse density modulated signals from the one or more converters. One or more of the inputs of the adder unit may be configured to receive respective multi-bit values.

The arithmetic unit may be configured to perform a signed addition function. The arithmetic unit may comprise a multiplexor with a first selectable input, a second selectable input, a selecting input, and an output that is equal to a signal at one of the first and second selectable inputs dependent on a signal received at the selecting input. The output of the multiplexor may be a multi-bit value. One of the plurality of inputs of the adder unit may be configured to receive the output of the multiplexor. The selecting input of the multiplexor may be configured to receive the one or more pulse density modulated signals from the one or more converters. The parameter register may be coupled to the first selectable input of the multiplexor. The second selectable input may be configured to receive a zero value. The second selectable input may be configured to receive an inverted value at the first selectable input.

The arithmetic unit may be configured to perform an unsigned multiplication function. The arithmetic unit may comprise an averager having an input and an output. The average may comprise a moving average or infinite impulse response filter. The output of the averager may be a multi-bit value. The output may be coupled to the first selectable input of the multiplexor.

The arithmetic unit ma comprise plurality of converters. Each converter may be configured to receive an input signal. Each converter may be configured to provide a respective pulse density modulated signal. A second of the plurality of converters may be configured to provide a second pulse density modulated signal to the input of the average. The second selectable input may be configured to receive a zero value. The second selectable input may be configured to receive an inverted value at the first selectable input.

The parameter register may be configured to store signed or unsigned values. The adder unit may be configured to add signed or unsigned values.

The arithmetic unit may be configured to perform an unsigned reciprocal function. The arithmetic unit may comprise an adder unit configured to receive a signal in accordance with a pulse density modulated signal from the one or more converters. The arithmetic unit may comprise a counter configured to increment a count each clock cycle of the pulse density modulated signal. The counter may be configured to provide the count as an input to the adder unit. The counter may be configured to be reset in accordance with a pulse density modulated signal derived from an output of the adder unit. The arithmetic unit may comprise a register configured to receive a remainder from the adder unit in a first clock cycle and provide the received remainder as one of the plurality of inputs to the adder unit in a subsequent clock cycle.

The arithmetic unit may be configured to perform a signed reciprocal function. The arithmetic unit may comprise an average configured to receive the pulse density modulated signal and provide an averaged signal. The arithmetic unit may comprise a counter configured to increment a count each clock cycle of the pulse density modulated signal and provide the count as an input to the adder unit. The arithmetic unit may comprise a comparison unit configured to compare the averaged pulse density modulated signal with the count and provide a modified pulse density modulated signal in accordance with the comparison. A reset for the counter may be configured to receive the modified pulse density modulated signal from the comparison unit.

The arithmetic unit may comprise an increment register for storing an increment value. The arithmetic unit may comprise a decrement register for storing a decrement value. The arithmetic unit may comprise a first adder unit for providing a modified pulse density modulated. The arithmetic unit may comprise a second adder unit. The decrementing value from the decrementing register may be provided as a decrementing input of the second adder unit. The arithmetic unit may comprise a first multiplexor that has a first selectable input configured to receive the increment value form the increment register and a second selectable input with a logic level zero input. The pulse density modulated signal may be provided to a selecting input of the multiplexor. The output of the first multiplexor may be provided as an input to a first adder unit. The arithmetic unit may comprise a second multiplexor that has a first selectable input coupled to an output of the first adder unit and an input of the second adder unit. A second selectable input of the second multiplexor may be coupled to an output of the second adder unit. A selecting input of the second multiplexor may be provided with the pulse density modulated output signal from the first adder unit. The arithmetic unit may comprise a register configured to receive the output from the second multiplexor in a first clock cycle and provide the output of the second multiplexor as one of the plurality of inputs to the first adder unit in a subsequent clock cycle.

The arithmetic unit may be configured to perform a combination of signed and/or unsigned arithmetic functions. The arithmetic unit may be configured to implement a proportional-integral control function of the control system.

According to a second aspect of the invention there is provided a power supply converter comprising:
a primary side;
a secondary side;
a transformer configured to transfer energy from the primary side to the secondary side; and
the control system of any preceding claim, wherein the control unit is configured to control a supply of energy to the transformer.

The input signal may be related to a voltage at the secondary side of the power supply converter. The power supply may comprise an opto-coupler configured to transfer the one or more pulse density modulated signals between the secondary side and the primary side.

Any arithmetic unit disclosed herein may be provided independently of the control system.

Embodiments will now be described by way of example with reference to the accompanying figures, in which:
Figure 1 illustrates a circuit diagram for a switched mode power supply with a control system that uses secondary side sensing and transmits signals from the secondary side to the primary side using an opto-coupler;
Figure 2 illustrates a block diagram of a generic control system for a switched mode power supply;
Figure 3a illustrates an example of a part of a control system for a switched mode power supply in which Proportional-Integrating control arithmetic processing is performed on multi-bit (e.g. binary) machine words;
Figure 3b illustrates a block diagram of an example pulse density demodulation unit;
Figure 3c illustrates a block diagram of another example pulse density demodulation unit;
Figure 3d illustrates a block diagram of an example pulse density demodulation unit with decimation;
Figure 4 illustrates an embodiment of a part of a control system for a switched mode power supply in which arithmetic processing is performed in a pulse density modulated domain and the related PDM modulators and demodulator;
Figure 5a illustrates an arithmetic unit for a control system for adding two or more PDM bit-streams together;
Figure 5b is a table illustrating an example series of logic states of the arithmetic unit of figure 5a;
Figure 6a illustrates an arithmetic unit for a control system for adding a multi-bit value to a PDM bit-stream;
Figure 6b is a table illustrating an example series of logic states of the arithmetic unit of figure 6a;
Figure 7a illustrates an arithmetic unit for a control system for multiplying two PDM bit-streams;
Figure 7b is a table illustrating an example series of logic states of the arithmetic unit of figure 7a;
Figure 8a illustrates an arithmetic unit for a control system for multiplying an unsigned multi-bit value by an unsigned PDM bit-stream;
Figure 8b is a table illustrating an example series of logic states of the arithmetic unit of figure 8a;
Figure 9 illustrates an arithmetic unit for a control system for multiplying a signed multi-bit value with a signed PDM bit-stream;
Figure 10a illustrates an arithmetic unit for a control system for multiplying two signed PDM bit-streams;
Figure 10b is a table illustrating an example series of logic states of the arithmetic unit of figure 10a;
Figure 11 illustrates a first arithmetic unit for a control system for dividing an unsigned PDM bit-stream (Reciprocal);
Figure 12a illustrates a second arithmetic unit for a control system for dividing an unsigned PDM bit-stream (Reciprocal);
Figure 12b is a table illustrating an example series of logic states of the arithmetic unit of figure 12a;
Figure 12c illustrates a profile of (analogue) input values and corresponding reciprocal value determined using the arithmetic unit of figure 12a;
Figure 13a illustrates an arithmetic unit for a control system for dividing a signed PDM bit-stream (Reciprocal);
Figure 13b illustrates a profile of input values and a profile of corresponding reciprocal values determined using the arithmetic unit of figure 13a;
Figure 14a illustrates an arithmetic unit for a control system for scaling an unsigned PDM bit-stream;
Figure 14b is a table illustrating an example series of logic states of the arithmetic unit of figure 14a;
Figure 15 illustrates a system comprising an embodiment of an arithmetic unit corresponding to the secondary control of figure 1;
Figure 16 illustrates a system comprising another arithmetic unit similar to that of figure 15; and
Figure 17 illustrates a system comprising another arithmetic unit similar to that of figure 15.

Power conversion control circuits are traditionally implemented using analogue electronics. Changing the implementation of the control system to use digital electronics enables a cost reduction as well as the provision of new features. However, the introduction of digital functionality into analogue systems introduces additional latency which means that conventional ADCs, DACs and DSP circuitry may be unsuitable for some control systems, such as power converter control systems. In particular, the extra propagation delay caused by the addition of components should be limited so that the stability of the system is not unduly effected.

A power adapter is an example of a controlled system where pulse density modulation can be used in to improve functionality whilst retaining adequate responsiveness in a power efficient manner. A power adapter takes AC electrical power from the mains and converts it to DC electrical power at a constant voltage (Vref). Variations of the mains (source) and output current (load) have a relation to the output voltage (Vvcc). A control loop is used to counter any distortion on Vvcc with respect to reference voltage Vref. In the case of a fly-back converter, the control loop is divided over two galvanic separated circuits. Often, an opto-coupler circuit is used to transfer an analogue signal from the secondary side to the primary side, as in figure 1.

Figure 2 illustrates a functional block diagram of a generic control system 200 for a power converter 202. The power converter 202 may be provided by a transistor, switch and associated discrete components such as those used in the flyback converter discussed with reference to figure 1. The control system 200 performs the functions of the flyback controller and secondary controller.

The control system 200 comprises an error, or difference, determining unit 204 that is configured to determine an error between an output voltage Vₒᵤₜ of the power converter 202 and a target, or reference voltage V_{ref}. A proportional and integrating (PI) regulator 206 ensures that the feedback loop remains stable. The regulator controls, via a power-switch controller 208, the amount of power which is converted by the power converter 202.

The stability of the control loop depends on the phase margin and gain margin of the regulator 206. For an analogue implementation of the regulator 206, the propagation delay is typically low and the controller may function adequately. However, it is desirable to implement processes within the control (feedback) loop in a digital space in order to improve the functionality of the system. As the output of the power converter 202 is a controlled analogue voltage, this signal needs to be converted to a digital signal before digital arithmetic can be applied. As the power converter is driven by a power switch, subsequent digital-to-analogue conversion is not necessarily required, because the switch can be controlled digitally by the power-switch controller 208.

When replacing parts of the feedback loop of the control system 200 with a digital implementation, the continuous-time nature of an analogue system is replaced by the discrete-time nature of a digital system. The discrete-time nature of the digital system implicitly introduces an extra propagation delay of at least half the sample-period of the sampling process. In order to limit the impact on system stability, this delay should minimised. This implies the uses of a high sample-rate.

In addition the phase of the sampling process of the digital implementation, with respect to the phase of the power-switch, will create an extra propagation delay. When these frequencies are not correlated, the worst-case propagation-delay is dominant in the stability of the system. In order to improve the stability of the system, this latency should also be minimised. Hence, both frequencies should be the same and their phase relation should be chosen such that a minimum latency causes least degradation of the stability of the system. This implies that the moment of sampling analogue values (at the secondary side) is locked to the moment the power-switch is driven (at the primary side), yet the timing of the power-switch depends on the amount of power which is to be converted and so additional complexity is added to designing such a system.

In summary, each DAC and ADC introduces an additional latency into the system, which has a negative impact on system stability. Furthermore, the DAC and ADC circuits have a discrete-time behaviour, which should be synchronized to the power switch timing, to prevent further propagation delays.

In order to be able to maintain a low latency during digital signal processing, which is a requirement for a feedback control loop, no decimation should be applied to the digitally converted pulse density modulated signals. Hence all processing should be done at an oversample clock rate. One solution to this problem is to demodulate the PDM bit-stream, perform all arithmetic operations using binary value representations. Calculations are performed at the rate of the bit-stream and the resulting binary values are modulated back to a PDM bit-stream.

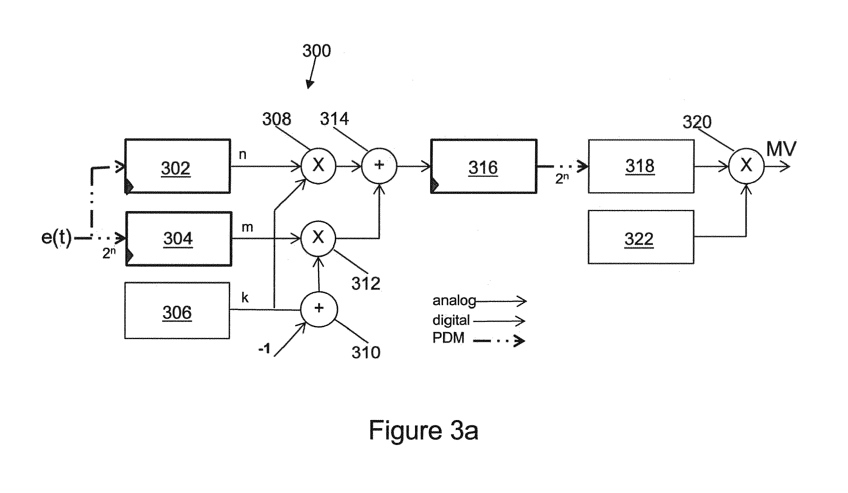

Figure 3a illustrates an example of a control system for a switched mode power supply in which arithmetic processing is performed on multi-bit binary words. The control system receives a pulse density modulated (PDM) input signal e(t) from a sigma delta modulator (not shown). The PDM input signal e(t) is related to a voltage at the secondary side of the power supply converter. The PDM input signal e(t) is provided to a PDM demodulator 302 and an integrator 304, each of which provides a multi-bit digital output. The term multi-bit digital output includes binary output, for example.

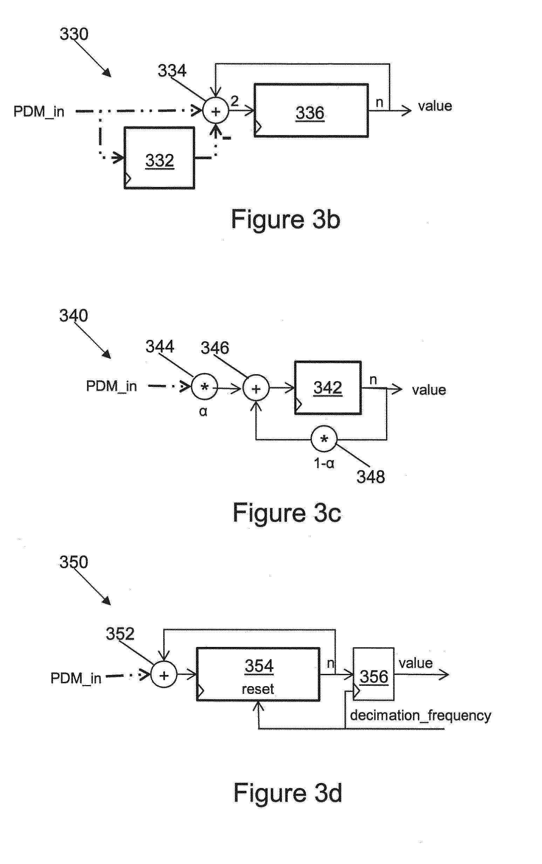

The demodulator 302 may be provided by a number of different methods. Three example demodulators are described with reference to figures 3b to 3d, as described further below.

Figure 3b illustrates a demodulator 330 comprising an adder 334 that is configured to add together a PDM input signal PDM_in and the PDM input signal after it has passed through a delay line 332, which provides a 2ⁿ delay in the signal. A multi-bit value output of the adder 334 is provided to an accumulation register 336 which provides a multi-bit output. The multi-bit output from the accumulation register 336 is also provided as an input to the adder 334.

The demodulator 330 provides a moving average function in order to determine the value of a PDM signal using the delay line 332, which can be implemented by a feed-forward shift-register of n register elements. However, such an implementation is relatively expensive.

Figure 3c illustrates a demodulator 340 comprising an infinite impulse response (IIR) register 342. The demodulator 340 is a more cost effective solution than the demodulator 330 due to the use of the IIR register 342. The IIR register 342 may provide adequately accurate performance (where the number of IIR register elements m=2⁻ⁿ).

The PDM input signal PDM_in is fed via a first multiplication unit 344 to an adder unit 346.

The first multiplication unit 344 multiplies the PDM input signal by a parameter α and provides a multi-bit output. Parameter α (in the range 0...1) determines the resolution of the demodulator 340 and at the same time its response-time. A small value of α requires a large register, providing accurate representation of the average input value, but has a slower response. A large value for α provides a course representation of the average input value, but has a faster response.

The adder unit 346 provides an input to the infinite impulse response (IIR) register 342. The output of the IIR register 342 is a demodulated multi-bit signal. The demodulated multi-bit signal is fed back as an input to the adder unit 346 via a second multiplication block 348. The second multiplication block 348 applies a 1- α multiplication factor to the multi-bit signal.

When decimation is allowed, another cost-effective technique can be used, subsampling of the pulse density modulated signal at a specific decimation rate. The decimation rate determines how many input samples are accumulated, hence determines the resolution of the demodulation.

Figure 3d illustrates a block diagram of an example pulse density modulation demodulator 350 with decimation. The demodulator 350 comprises an adder unit 352 that receives a PDM input signal PDM_in and provides a multi-bit output signal to an accumulator 354. A multi-bit output of the accumulator 354 is fed back as an input to the adder unit 352. At the decimation rate the multi-bit output of the accumulator 354 is also copied to a register which provides an output value. A decimation frequency is used both to trigger a reset of the accumulator 354 and to trigger the register 356 to update its output value.

In case decimation is desired, the type of decimation filter should be selected. The lowest cost decimation filter is provided by a 1^{st} order filter, whereas higher performance can be achieved when using a 3^{rd} order filter.

Returning to figure 3a, a parameter register 306 is provided in order that the PDM input signal e(t) can be scaled in the digital domain. A first multiplication unit 308 multiplies an n-bit output of the PDM demodulator 302 by a k-bit parameter stored in the parameter register 306. A first addition unit 310 subtracts the k-bit parameter from a fixed value of 1. A second multiplication block 312 multiplies an m-bit output of the integrator 304 by a k-bit output of the first addition block 310. A second addition block 314 adds the output of the first multiplication block 308 to the output of the second multiplication block 312. The output of the second addition block 314 is equal to k * n + (1- k) * m.

A PDM modulator 316 provides a PDM output signal from the multi-bit output of the second addition block 314. A sequence of 2n bits corresponds to a value at the input resolution. The demodulator 302 and modulator 316 are only required in order to translate signals between the PDM and analogue domains. A low pass filter 318 converts the PDM output signal into an analogue signal. In this example, an analogue multiplication block 320 multiplies the analogue signal by an analogue external parameter 322. A potential divider is an example of a passive implementation of the analogue multiplication block 320 and so a potentiometer could be used to set the external parameter 322.

This example requires significantly increased processing power and energy consumption compared to an analogue system because it has to processes multi-bit values at the oversampling rate of the sigma delta (ΣΔ) ADC in order to reduce the latency of the system to be comparable with an analogue system. That is, the processing requires a significant amount of processing power because the signal is demodulated, modulated and the binary arithmetic runs at a much higher rate than the actual sample-rate of the system.

The present disclosure largely relates to a control system in which the discrete-time effects caused by implementation of digital signal processing methods are minimised, which may also avoid the need for synchronization of the power switch timing and processing.

When introducing digital signal processing in an analogue system, analogue-to-digital and digital-to-analogue converters (ADC and DAC) are required. However, these functions introduce additional latency, or propagation delay, in the feedback loop, without providing any further functional benefit. The main source of the additional propagation delay is the discrete-time nature of conventional digital systems. As discussed previously, increasing the latency of the control loop has a negative impact on the stability of the power conversion system and so should be avoided.

A delta sigma ADC without decimation creates a Pulse Density Modulated (PDM) bit-stream which is a digital representation of an analogue input signal value. No significant latency is introduced by this conversion. When processing the PDM signal without decimation, the signals still resemble time-continuous (analogue) signals and low latency can be preserved. This method enables advanced digital signal processing, while preserving the time-continuous nature of the power conversion system. Implementations of such converters may therefore require less processing power and so exhibit reduce complexity and power consumption compared to other methods of signal conversion and processing.

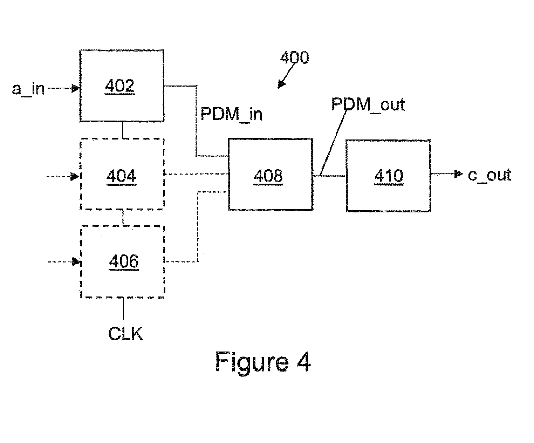

Figure 4 illustrates an embodiment of a control system 400 for a switched mode power supply in which arithmetic processing is performed in a pulse density modulated domain. The control system comprises one or more converters 402, 404, 406, an arithmetic unit 408 and a demodulator unit 410.

A first converter 402 can be provided by a sigma delta converter that is configured to receive an analogue input signal a_in and provide a pulse density modulated signal in accordance with the input signal. The input signal a_in may be related to a voltage or current at the secondary side of the switched mode power supply. Alternatively, the input signal may be in a multi-bit form, in which case the converter is a multi-bit to PDM converter, or a PDM signal.

In the case where a plurality of converters 402, 404, 406 are provided, each converter may be configured like the first converter 402. All of the converters 402, 404, 406 are configured to operate at the same sample clock rate CLK in order that their outputs can be processed together.

The arithmetic unit 408 is configured to perform an arithmetic function on the one or more pulse density modulated signals PDM_in generated by the converters 402, 404, 406. Of course, the arithmetic unit 408 could be provided by a number of units or sub-units. The arithmetic unit 408 provides a pulse density modulated output PDM_out. The arithmetic function may be performed directly on the pulse density modulated signals in the pulse density modulated domain. The system therefore does not necessarily require PDM demodulator and modulator circuitry discussed with reference to figure 3. Furthermore, there is the option to only use the basic arithmetic function ADD in some implementations. As this method reduces complexity, it also reduces the required processing power and power consumption of the system 400. The arithmetic unit 408 may be further configured to perform an arithmetic function on the one or more pulse density modulated signals in combination with one or more multi-bit values.

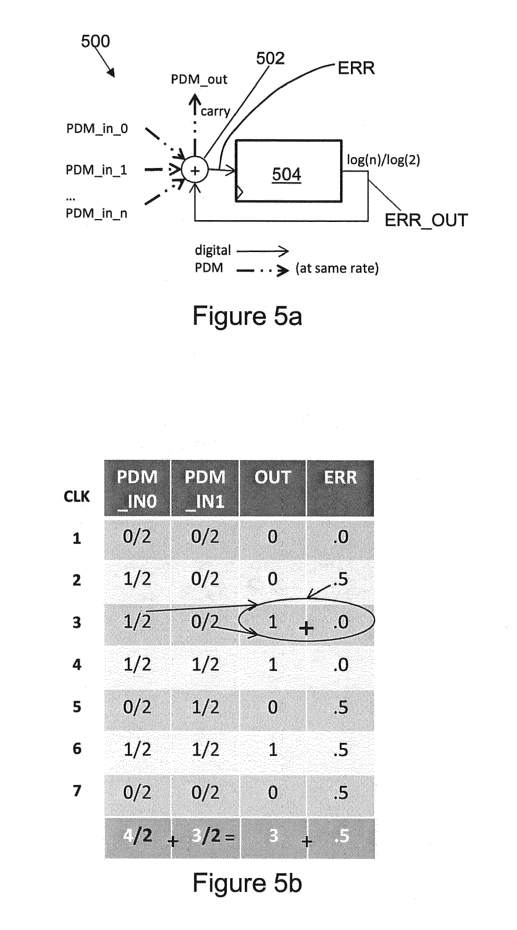

Embodiments of arithmetic units that provide the following functions are described with reference to figures 5 to 15:
- Add, Subtract (PDM, PDM) & (PDM, binary)
- unsigned & signed multiplication (PDM, PDM) & (PDM, binary)
- unsigned & signed reciprocal (division 1/x) (PDM)

Functions such as integration and differentiation may also be implemented in the PDM domain by combining these base arithmetic circuits listed above.

The demodulator unit 410 is configured to receive a pulse density modulated signal and provide a control signal c_out in accordance with the one or more input signals. The control signal may be an analogue signal, or a digital signal. In the case of a switched mode power supply that is controlled by a switch, digital switching may be desirable.

By utilizing digital arithmetic in the pulse density modulated domain, the control system 400 provides a compact, low-power and low-latency method that enables digital signal processing in a control loop for a power conversion circuit.

One method of adding two PDM bit-streams together is to time-interleave their values. This method maintains the resolution of the input signals, yet doubles the sample-rate of the PDM output bit-stream.

Alternatively, two or more PDM bit-streams inputs can be added into a single PDM bit-stream output, by adding their individual bit values at the bit-stream rate. Next to this, also a feedback signal comprising the accumulated quantisation error is added to it.

Figure 5 illustrates such an arithmetic unit for adding two or more PDM bit-streams together. The arithmetic unit comprising an adder unit 502 and a remainder register 504. Then adder unit has a plurality of inputs PDM_in_0, PDM_in_1... PDM_in_n, ERR_OUT, a carry bit output, PDM_out and a remainder output ERR.

The remainder register 504 is configured to receive a remainder signal from the remainder output ERR and provide the received remainder as one of the plurality of inputs ERR_OUT to the adder 502 in a subsequent clock cycle.

The plurality of inputs include pulse density modulated signals PDM_in_0, PDM_in_1... PDM_in_n and a multi-bit signal ERR_OUT. All of the PDM inputs have a common clock rate, as does the ERR_OUT signal of the remainder register 504. The adder unit 502 is configured to add together signals at the plurality of inputs, scale the result back to the available PDM range by dividing result of this addition by the number of plurality of inputs, and add the previous remainder value (ERR_OUT signal). A cost-effective embodiment of the scaling divider function is a bit-shift operation; for 2 PDM inputs, shift-right 1 bit; for 4 PDM inputs, shift-right 2 bit; for n-inputs shift-right ROUNDUP(log(n)/log(2)). The carry bit output if the addition drives the PDM output PDM_out. The remainder signal ERR is equal to the result of the addition, excluding the carry bit. When the result of this addition is smaller than the weight of a PDM output bit, the PDM output value PDM_out is set to logic level '0' (low) and the remaining value of the addition is stored in the error register 504. This value is used in the next cycle to propagate the quantisation error and blend it into the next input values. When the result of the addition is larger than the weight of a PDM output bit, the output value is set to logic level '1' (high) and the weight of the output bit is subtracted from the value of initial addition and this value is stored in the error register 504. The bit-stream rate of PDM input signals PDM_in_0, PDM_in_1 ... PDM_in_n and PDM output signal PDM_out are the same, allowing an efficient implementation.

Quantisation error is accumulated in the error register 504 and used in an error-diffusion process. The size of the error register 504 depends on the number of the plurality of inputs of the adder 502 (excluding the feedback input from the error register 504). A cost-effective embodiment can be achieved for 2ⁿ inputs, as the scaling divider function can be implemented as a shift-right operation. The quantisation error is accumulated in the error register 504. When the adder 502 overflows, the PDM output signal PDM_out is driven to logic level '1', and implicitly takes care of the required subtraction from the error register 504. When there is no overflow, the PDM output signal PDM_out is driven to logic level '0'.

Figure 5b is a table illustrating an example series of logic states of the arithmetic unit 500 of figure 5a for a given series of inputs PDM_in_0, PDM_in_1 over seven clock cycles. It can be seen from the table that the carry bit output PDM_out takes an integer value. The value is equal to the two inputs PDM_in_0, PDM_in_1 from the current clock cycle (e.g. CLK =3) and the remainder output ERR from the previous clock cycle (e.g. CLK = 2, which is now provided at the remainder output ERR_OUT) all divided by the weighting value (the number of inputs to the adder 502 is two, in this example, not counting the feedback from the register 504). The remainder of the sum of these values is provided at the remainder output ERR. That is, the remainder output ERR is equal to the sum of the added together signals at the plurality of inputs PDM_in_0, PDM_in_1, ERR_OUT divided by the weighting value, minus a value of the signal at the carry bit output PDM_out.

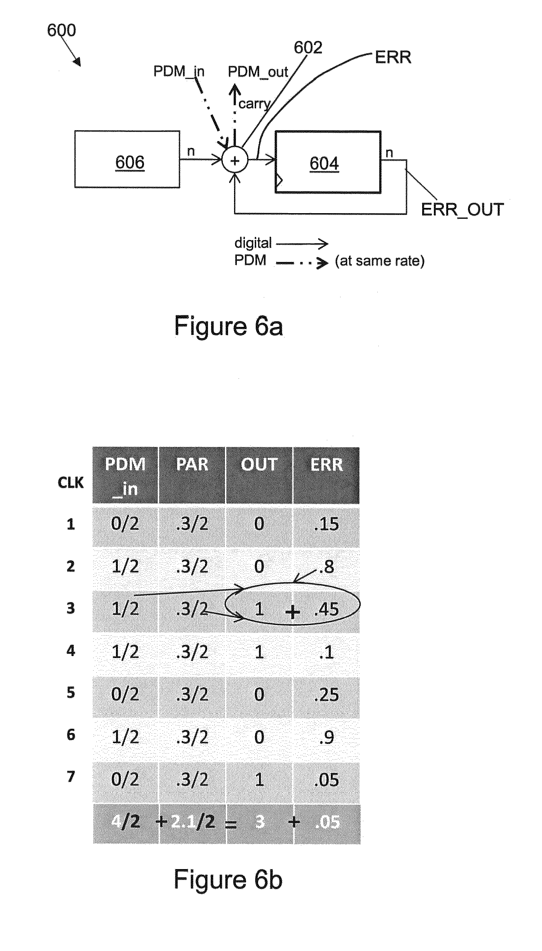

Figure 6a illustrates an arithmetic unit 600 for a control system for adding a multi-bit value to a PDM bit-stream. The arithmetic unit 600 of figure 6 comprises an adder unit 602 and a remainder register 604 similar to those described with reference to figure 5 and in addition a parameter register 606 that provides a multi-bit digital value (with maximum value corresponding to PDM logic level '1') to one of the plurality of inputs of the adder unit 602.

A PDM bit-stream, a multi-bit binary parameter value and the previous remainder value are added. A feedback signal ERR_OUT from the bit-shifting register 604 comprising the accumulated quantisation error is also added to the PDM input signal PDM_in and the parameter from the parameter register 606. When the result of this addition is smaller than the weight of a PDM output bit, the value of the PDM output PDM_out is set to logic level '0' and the remaining value of the addition is stored in the error register 604. This value is used in the next cycle to propagate the quantisation error and blend it into the next set of input values. When the result of the addition is larger than the weight of a PDM output bit, the value of the PDM output signal PDM_out is set to logic level '1' and the weight of the output bit is subtracted from of the value of initial addition and this value is stored in the error register 604. The bit-stream rate at PDM input and output are the same, allowing for an efficient implementation.

The size of the error register 604 depends on the number of inputs which are added and the resolution of the parameter register 606. A cost-effective implementation can be achieved when the parameter fits into an n-bit register (without a remainder). Quantisation error is accumulated in the error register 604. When it is overflowing, the PDM output signal PDM_out is driven to logic level '1', and implicitly takes care of the required subtraction. When there is no overflow, the PDM output signal PDM_out is driven to logic level '0'.

Figure 6b is a table illustrating an example series of logic states of the arithmetic unit of figure 6a for a given PDM input signal PDM_in and a parameter register value PAR over seven clock cycles. It can be seen from the table that the carry bit output (PDM output signal) PDM_out takes an integer bit value. The integer bit value is equal to the PDM input signal PDM_in and the parameter register input PAR from the current clock cycle (e.g. CLK =3) added to the remainder output ERR from the previous clock cycle (e.g. CLK = 2, which is now provided at the remainder output ERR_OUT of the error register 604) all divided by a weighting value (which is two, the number of adder unit inputs, in this example, not counting the feedback from the register 604). The remainder of the sum of these values is provided at the remainder output ERR. That is, the remainder output ERR is equal to the sum of the added together signals at the plurality of inputs PDM_in, PAR, ERR_OUT divided by the weighting value, minus a value of the signal at the carry bit output PDM_out.

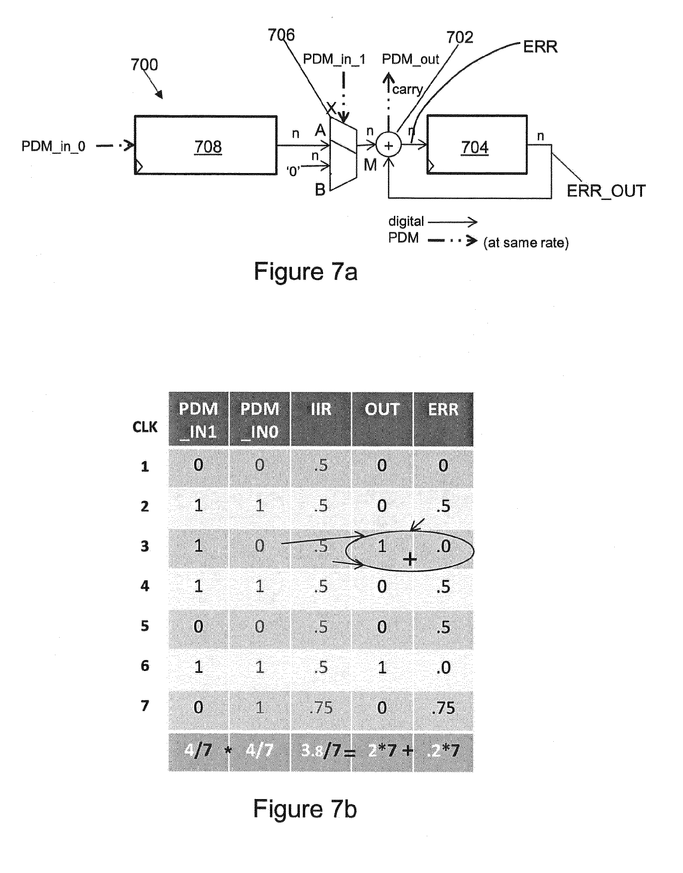

Figure 7a illustrates an arithmetic unit 700 for a control system for multiplying a first PDM input signal PDM_in_0 and a second PDM input signal PDM_in_1. The arithmetic unit 700 comprises an adder unit 702 and a bit-shifting register 704 similar to those described with reference to figure 5 and 6. In addition, the arithmetic unit 700 comprising a multiplexor 706 with a first selectable input A, a second selectable input B, a selecting input X, and an output M coupled to one of the plurality of inputs of the adder unit 702.

The selecting input X of the multiplexor 706 is configured to receive the second PDM_in_1 from a sigma delta converter (not shown). The value at the output M of the multiplexor 706 is equal to a signal at one of the first and second selectable inputs A, B dependent on the state of the second PDM input signal PDM_in_1 received at the selecting input X.

A moving average or infinite impulse response filter 708 is provided. The filter 708 receives a first PDM input signal PDM_in_0 at its input and provides an averaged multi-bit value at its output. The output pf the filter 708 is coupled by its output to the first selectable input A of the multiplexor 706.

The second selectable input B of the multiplexor 706 is configured to receive a logic level zero value input.

Multiplication is implemented using a repeated addition algorithm. In binary multiplication, a weighted bit from a first number decides whether a weighted second number is to be accumulated. Such an algorithm can also be applied to PDM codes values, where each bit from a first number has the same weight and is used to decide whether a second number is to be accumulated.

In the arithmetic unit 700, two PDM bit-streams PDM_in_0, PDM_in_1 at the bit-stream rate are multiplied into a single bit-stream output, by conditionally (dependent on the second PDM input PDM_in_1) accumulating the averaged value of a first PDM input PDM_in_0.

When the result of this accumulation is smaller than the weight of the carry output but (PDM output bit) of the adder unit 702, the value of PDM_out is set to logic level '0' (low) and the remaining value ERR of the addition is stored in the error register 704. This value is used in the next clock cycle to propagate the quantisation error and blend it into the next set of input values. When the result of the addition is larger than the weight of the carry output, the value of the carry output signal PDM_out is set to logic level '1'(high) and the weight of the output-bit is subtracted from the value of initial addition and this value ERR is stored in the error register 704.

The size of the error register 704 depends on the resolution of the averaging filter 708. A cost-effective embodiment can be achieved when the multi-bit representation of the averaged value fits into an n-bit register (without leaving a remainder). In this example the quantisation error ERR is effectively accumulated in the error register 704. When the quantisation error ERR overflows, the carry output signal PDM_out is driven to logic level '1' (high), and implicitly takes care of the required subtraction. When there is no overflow, signal PDM_out is driven to logic level '0' (low).

A multiplication creates extra resolution at its output, this becomes tangible when more bits are averaged than the multi-bit representation of the averaged value. As the PDM output signal PDM_out has the same rate as the input streams, the extra resolution of the PDM signal only becomes visible when averaging the output over a longer period of time.

When either of the PDM inputs PDM_in_0, PDM_in_1 has a logic level value of zero (low), the carry output PDM_out of the adder unit 702 is driven to logic level '0' (low). The specific implementation of the multiplier is dependent on the definition of value of logic level zero (low) in the binary domain, as well as the PDM domain.

For multiplication the definition of the value zero is relevant, if one of the input values is zero, the output must also be zero. There are two positions for defining the zero level: zero is the lowest value in the range (unsigned logic) or zero is the middle value of the range (signed logic).

For binary values a two's complement notion is used for this purpose:
- unsigned values: min.="0000", zero="0000", max.="1111"
- signed values: min.="1000", zero="0000", max="0111"
(where the most significant bit MSB is the sign-bit, if the MSB is logic level '1' (high) then the sign is negative)

For PDM values the average value of the sign-bit-stream is used for this purpose:
- unsigned values:
   min.="0000000000000000", zero="0000000000000000", max.="1111111111111111"
- signed values:
   min.="0000000000000000", zero="0101010101010101 ", max.="1111111111111111"

If the average value < 50% then the sign is negative, if the average value = 50% then the value is zero, otherwise, the sign is positive)

The arithmetic unit 700 is also suitable for multiplying signed and unsigned PDM bit-streams. In the case of unsigned bit streams, the error register 704 stores unsigned values. A first PDM bit-stream stream PDM_in_0 can be multiplied with a of a second PDM bit-stream PDM_in_1, creating a PDM output signal PDM_out. The first PDM input signal PDM_in_0 is averaged, using the moving average or Infinite Impulse Response (IIR) filter 708. This averaged value is conditionally added to the PDM modulator, depending on the value of the second PDM input signal PDM_in_1. If the second PDM input signal PDM_in_1 is at logic level '1' then the averaged value of the first PDM input signal PDM_in_0 is added to the accumulating error register 704, otherwise the value is not added. That is, if the second PDM input signal PDM_in_1 is at logic level '0' then the 0 is added to the accumulating error register 704.

When the result of this accumulation is smaller than the weight of a PDM output bit, the value of the PDM output PDM_out is set to logic level '0' and the remaining value of the addition is stored in the error register 704. This value will be used in the next cycle to propagate the quantisation error and blend it into the next input values. When the result of the addition is larger than the weight of a PDM output PDM_output bit, the value of PDM_out is set to logic level '1' and the weight of the output-bit is subtracted from of the value of initial addition and this value is stored in the error register 704. As with the previous examples, the bit-stream rate of PDM input and output signals are the same, allowing for an efficient implementation.

The size of the error register 704 depends on the resolution of the averaging register 708. A cost-effective embodiment can be achieved when this multi-bit representation of the averaged value fits into an n-bit register (without a remainder). Quantisation error is accumulated in the error register 704. When it is overflowing, the PDM output signal PDM_out is driven to logic level '1', and implicitly takes care of the required subtraction. When there is no overflow, the PDM output signal PDM_out is driven to logic level '0'. The value stored in the averaging register 708 is in the range between zero and one.

When either PDM input has an unsigned zero value (e.g....00000000...), the PDM output also has an unsigned zero value (...00000000...).

Figure 7b is a table illustrating an example series of logic states of the arithmetic unit of figure 7a for a given PDM input PDM_in and a parameter register value over seven clock cycles. The carry bit output PDM_out takes an integer bit value. The integer value is equal to the PDM inputs PDM_in_1 multiplied by the filter output at the first selectable input A of the multiplexor 706 from the current clock cycle (e.g. CLK =3) added to the remainder output ERR from the previous clock cycle (e.g. CLK = 2, which is now provided at the remainder output ERR_OUT). The remainder of the sum of these values is provided at the remainder output ERR of the adder unit 702.

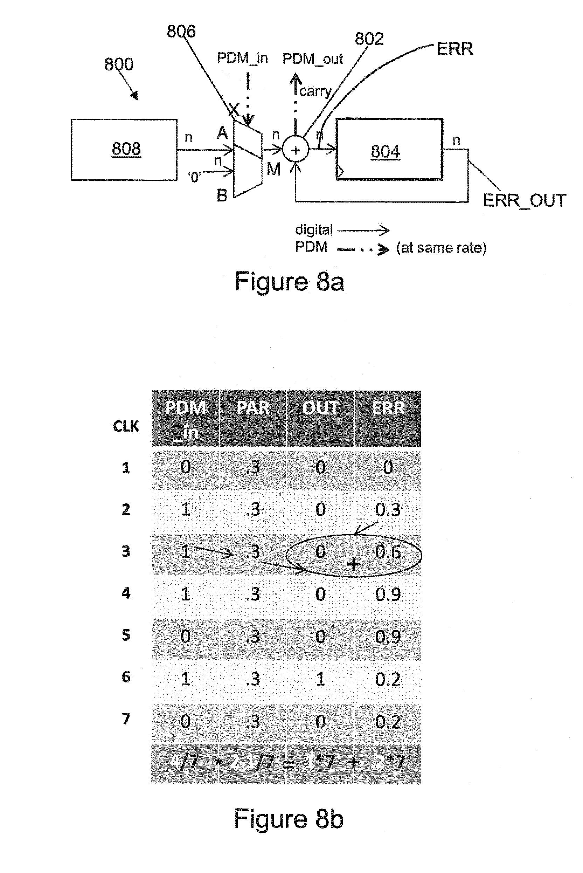

Figure 8a illustrates an arithmetic unit 800 for multiplying an unsigned multi-bit value by an unsigned PDM bit-stream. The arithmetic unit 800 comprises an adder unit 802, a bit-shifting register 804 and a multiplexor 806 similar to those described with reference to figure 7a. The multiplexor 806 therefore has a first selectable input A, a second selectable input B, a selecting input X, and an output M coupled to one of the plurality of inputs of the adder unit 802.

The selecting input X of the multiplexor 806 is configured to receive a PDM input signal PDM_in from a sigma delta converter (not shown). The value at the output M of the multiplexor 806 is equal to a signal at one of the first and second selectable inputs A, B dependent on the state of the PDM input signal PDM_in received at the selecting input X.

A parameter register 808 is coupled with, and provides a multi-bit signal to, the first selectable input of the multiplexor. The error register may store unsigned values. The second selectable input B of the multiplexor 806 receives a logic level zero value input.

The PDM bit-stream PDM_in is multiplied with a binary value of a parameter from the parameter register 808 creating a PDM bit-stream output PDM_out by conditionally adding the binary value of the parameter depending on the value of the PDM input signal PDM_in. If the PDM input signal PDM_in is logic level '1' then the parameter value is added to the accumulating error register 804, otherwise the parameter value is not added.

When the result of this accumulation is smaller than the weight of the carry output bit (PDM output bit), the value of carry output signal PDM_out is set to logic level '0' and the remaining value of the addition is stored in the error register 804. This stored value is presented at the output ERR_OUT of the error register 804 and used in the next clock cycle to propagate the quantisation error and blend it into the next input values. When the result of the addition is larger than the weight of a carry output bit, the value of PDM output signal PDM_out is set to logic level '1' and the weight of the carry output PDM_out bit is subtracted from the value of initial addition and this value is stored in the error register 804.

The size of the error register 804 depends on the resolution of the parameter register 808. A cost-effective embodiment can be achieved when the parameter fits into a n-bit register. Quantisation error is accumulated in the error register 804. When the adder unit 802 overflows, the PDM output signal PDM_out at the carry bit output of the adder unit 802 is driven to logic level '1' (high), and implicitly takes care of the required subtraction. When there is no overflow, the carry bit output signal PDM_out is driven to logic level '0' (low).

A cost-effective embodiment can be achieved for inputs that fit into an n-bit register. When the PDM output value is at logic level '1', the overflowing adder unit 802 takes care of the required subtraction. The value stored in the parameter register 808 may be in the range between zero and one.

When either PDM input has an unsigned zero value (e.g....00000000...) or the parameter register 808 has unsigned zero (000) value, the PDM output PDM_out of the adder unit 802 also has an unsigned zero value (e.g....00000000...).

Figure 8b is a table illustrating an example series of logic states of the arithmetic unit 800 of figure 8a for a given PDM input signal PDM_in and a parameter register value PAR over seven clock cycles. The carry bit output (PDM output signal) PDM_out takes an integer bit value. The integer bit value is equal to the PDM inputs PDM_in 1 multiplied by the filter output at the first selectable input A of the multiplexor 706 from the current clock cycle (e.g. CLK =3) added to the remainder output ERR from the previous clock cycle (e.g. CLK = 2, which is now provided at the remainder output ERR_OUT). The remainder of the sum of these values is provided at the remainder output ERR of the adder unit 702.

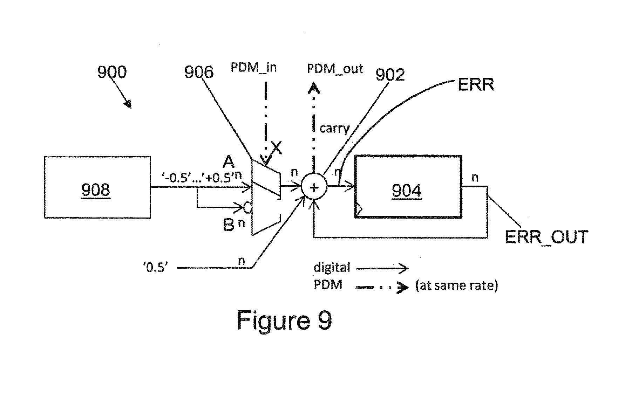

Figure 9 illustrates an arithmetic unit 900 for a control system for multiplying a signed multi-bit value with a signed PDM bit-stream signal PDM_in. The arithmetic unit 900 has an adder unit 902, an error register 904, a multiplexor 906 and a parameter register 908 which are similar to the corresponding components of figure 8a, except that a number of changes have been made so that the arithmetic unit 900 is suitable for handling signed values. Specifically, the parameter register 908 provides a signed parameter value to the first selectable input A of the multiplexor 906 and an inverted value of the signed parameter value to the second selectable input B of the multiplexor 906. The adder 902 also has an additional multi-bit input with a value of 0.5.

A signed PDM input signal PDM_in can be multiplied with a signed multi-bit value creating a PDM output signal PDM_out by conditionally adding the signed multi-bit value of the parameter to the error register 904, depending on the value of the PDM input signal PDM_in. If the PDM input signal PDM_in is at logic level '1' (high) then the parameter value is added to the accumulating error register, otherwise the parameter value is subtracted because the inverted parameter is added.

The value stored in the parameter register is in the range between minus one and one and divided by 2 to reduce the value range before it is sent to the multiplexer 906. When the parameter is zero, PDM_out will generate an alternating stream of logic level '1's and logic level '0's, representing a zero value signal. When the parameter value is one and PDM input signal PDM_in is one, the PDM output generates a stream of logic level '1's, representing plus one. When the parameter value is minus one and PDM input signal PDM_in is one, the PDM output generates a stream of logic level '0's, representing minus one. When the parameter value is one and PDM input signal PDM_in is minus one, the PDM output generates a stream of logic level '0's, representing minus one. When the parameter value is minus one and PDM_in is minus one, the PDM output generates a stream of logic level '1's, representing plus one.

When the result of this accumulation is smaller than the weight of a PDM output bit, the value of the PDM output signal PDM_out is set to logic level '0' and the remaining value ERR of the addition is stored in the error register 904. This value is used in the next cycle, where it is presented at the output ERR_OUT of the error register 904 to propagate the quantisation error and blend it into the next set of input values. When the result of the addition is larger than the weight of a PDM output bit, the value of the PDM output signal PDM_out is set to logic level '1' and the weight of the output-bit is subtracted from of the value of initial addition and this value ERR is stored in the error register 904. As in previous examples, the bit-stream rate of the PDM input PDM_in and PDM output PDM_out are the same, allowing for an efficient implementation.

The size of the error register 904 depends on the resolution of the parameter register 908. A cost-effective embodiment can be achieved when the parameter fits into an n-bit register. The quantisation error is accumulated in the error register 904. When the adder unit 902 overflows, the PDM output signal PDM_out is driven to logic level '1', and implicitly takes care of the required subtraction. When there is no overflow, signal PDM_out is driven to logic level '0'.

The output of the parameter register 908 is scaled to a new range, by reducing the value with factor 0.5 and adding 0.5 to it. These values are conditionally provided to the PDM modulator (see diagram).

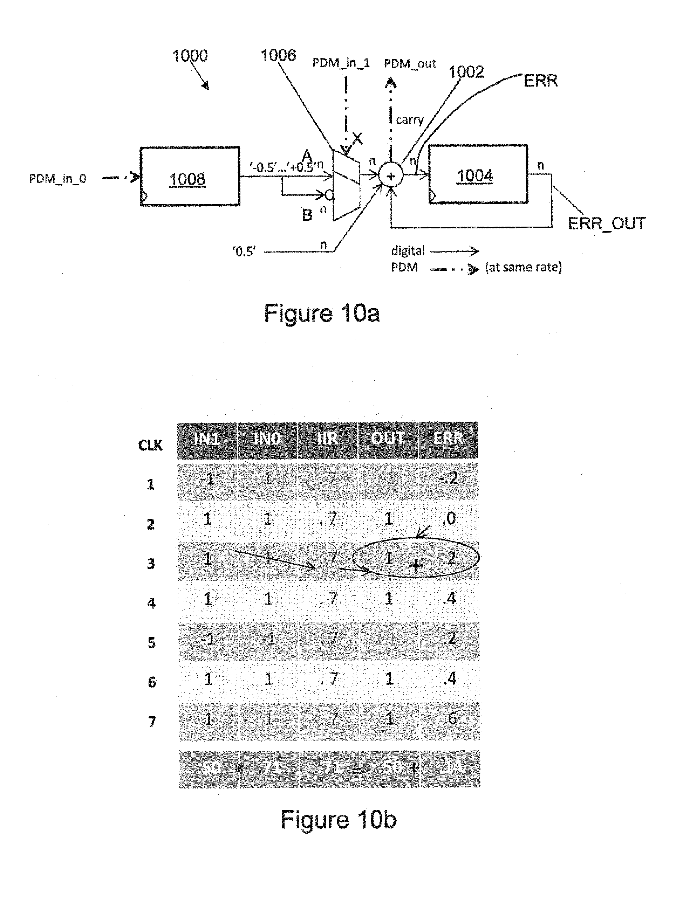

Figure 10a illustrates an arithmetic unit 1000 for multiplying a first signed PDM signal PDM_in_0 and a second signed PDM signal PDM_in_1 to create a PDM output signal PDM_out. The arithmetic unit 1000 has an adder unit 1002, an error register 1004, a multiplexor 1006 and a filter 1008 which are similar to the corresponding components of figure 7a, except that a number of changes have been made so that the arithmetic unit 1000 is suitable for handling signed values. Specifically, the filter 1008 provides a signed averaged value to the first selectable input A of the multiplexor 1006 and an inverted averaged value to the second selectable input B of the multiplexor 1006. The adder 1002 also has an additional multi-bit input with a value of 0.5.

The first PDM input signal PDM_in_0 is averaged using the moving average or Infinite Impulse Response (IIR) filter 1008. This averaged value is conditionally provided to the PDM modulator (provided by the adder unit 1002 and error register 1004), depending on the value of the second PDM input signal PDM_in_1. If the second PDM input signal is at a logic level '1' then the averaged value of the first PDM input signal PDM_in_0 is added to the accumulating error register 1004. Otherwise, the inverted averaged value is added to the error register 1004.

The value ERR stored in the error register 1004 is in the range between minus one and one. When the register is zero, PDM output generates an alternating stream of logic level '1's and logic level '0's, representing a zero value. When the averaged value of the first PDM input signal PDM_in_0 is one and the second PDM input signal PDM_in_1 is one, the PDM output generates a stream of logic level '1's, representing plus one. When the averaged value of the first PDM input signal PDM_in_0 is minus one and the second PDM input signal PDM_in_1 is one, the PDM output generates a stream of logic level '0's, representing a value of minus one. When the averaged value of the first PDM input signal PDM_in_0 is one and the second PDM input signal PDM_in_1 represents a value of minus one, the PDM output generates a stream of logic level '0's, representing a value of minus one. When the averaged value of the first PDM input signal PDM_in_0 represents minus one and PDM_in represents minus one, the PDM output generates a stream of logic level '1's, representing a value of plus one.

When the result of this accumulation by the adder 1002 is smaller than the weight of a PDM output bit, the value of the PDM output signal PDM_out is set to logic level zero '0' and the remaining value ERR of the addition is stored in the error register 1004. This value ERR is used in the next cycle to propagate the quantisation error and blend it into the next input values. When the result of the addition is larger than the weight of a PDM output bit, the value of the PDM output signal PDM_out is set to logic level '1' and the weight of the PDM output bit is subtracted from of the value of initial addition, and this value ERR is stored in the error register 1004.

The size of the error register 1004 depends on the resolution of the averaging filter 1008. A cost-effective embodiment can be achieved when the parameter fits into a n-bit register (without leaving a remainder). Quantisation error is accumulated in the error register 1004. When it is overflowing, the PDM output signal PDM_out is driven to logic level '1', and implicitly takes care of the required subtraction. When there is no overflow, signal PDM_out is driven to logic level '0'.

The effect of the arithmetic unit 1000 is that the output of the averaging register 1008 is scaled to a new range, by reducing the value by a factor of 0.5 and adding 0.5 to it. These values are conditionally provided to the PDM modulator (as shown in figure 10).

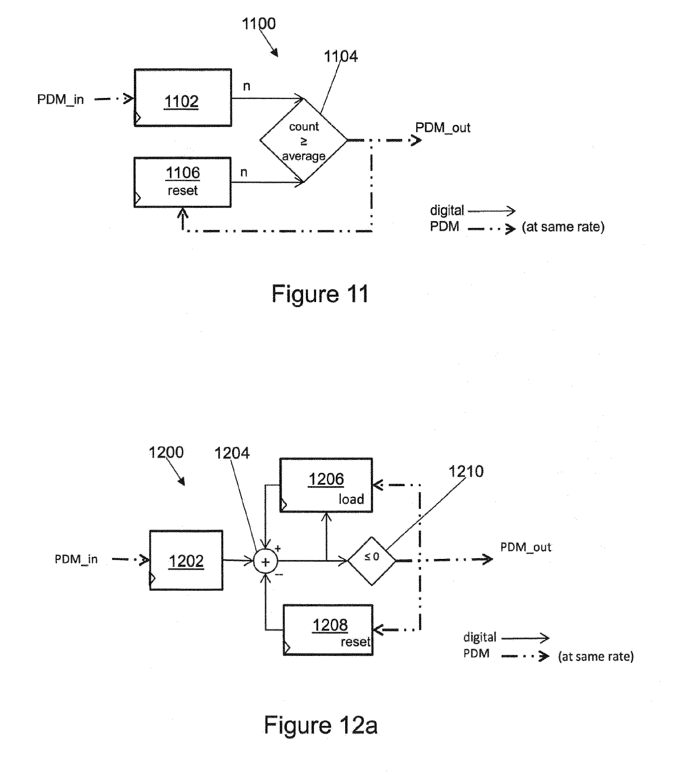

Figure 11 illustrates a first arithmetic unit 1100 for dividing an unsigned PDM bit-stream (Reciprocal). The first arithmetic unit 1100 comprises a moving average or Infinite Impulse Response (IIR) filter 1102 configured to receive a PDM input signal PDM_in and provide an averaged signal to a comparison unit 1104. The comparison unit 1104 compares the output of the filter 1102 with a count of a counter 1106 and provides a PDM output signal PDM_out. The counter 1106 increments its count in accordance with the number of clock cycles of the PDM_in signal that have elapsed. A reset for the counter is coupled to the PDM output of the comparison block.

The PDM input signal PDM_in_1 is converted to its reciprocal value by the arithmetic unit 1100, creating a PDM output signal PDM_out. The PDM input signal (PDM_in) is averaged, using the moving average or Infinite Impulse Response (IIR) filter 1102. For each new bit the averaged value is compared with a counter value. If the counter value is equal or larger than the averaged value, the PDM output signal PDM_out is set to logic level '1', otherwise the PDM output signal PDM_out is set to logic level '0'. The bit-stream rate of PDM input and output are the same, allowing for an efficient implementation. The arithmetic unit uses the averaged input value provided by the filter 1102 to count periods of time (T) and translates these time periods into a frequency (f) using the reciprocal relationship f=1/T.

When the output of the filter 1102 is zero, the PDM output signal PDM_out generates a stream of logic level '1's. When the averaged value provided by the filter 1102 is one, the PDM output signal PDM_out generates a stream of logic level '0's, representing a value close to zero.

When the PDM input signal PDM_in represents a value of a half, the PDM output signal PDM_out generates an alternating stream of logic level '1's and '0's, representing a value of a half, which is incorrect. To correct for this situation, the input value may be scaled by dividing it by half the binary bit-range, e.g. divide by 16 (4bit), when using a 255 (8bit) range. When the average input is less than half-range, the PDM output may be inverted

Figure 12a illustrates a second arithmetic unit 1200 for dividing an unsigned PDM bit-stream (Reciprocal). The second arithmetic unit 1200 comprises a moving average or Infinite Impulse Response (IIR) filter 1202 configured to receive a PDM input signal PDM_in and provide an averaged multi-bit signal to an adder unit 1204. The adder unit 1204 is arranged to provide a multi-bit signal to an error register 1206, which performs a similar function to the error register of figure 5a. The adder unit 1204 also adds a signal from the error register 1206 and a counter 1208 in order to generate its output. The counter 1106 increments its count in accordance with the number of clock cycles of the PDM input signal PDM_in that have elapsed.

A converter unit 1210 receives the multi-bit signal output of the adder unit 1204 and converts it into a PDM output signal PDM_out. A logic level '1' is generated at the PDM output when the input value is smaller or equal to 1, else it will generate a logic level '0'. A reset of the counter 1208 is coupled to the PDM output of the converter unit 1210, hence each time a logic level '1' is generated the counter is reset. The PDM output signal PDM_out is also provided to the error register, each time a logic level '1' is generated the value of the adder 1204 is output this remainder value is used as offset for the next PDM cycle.

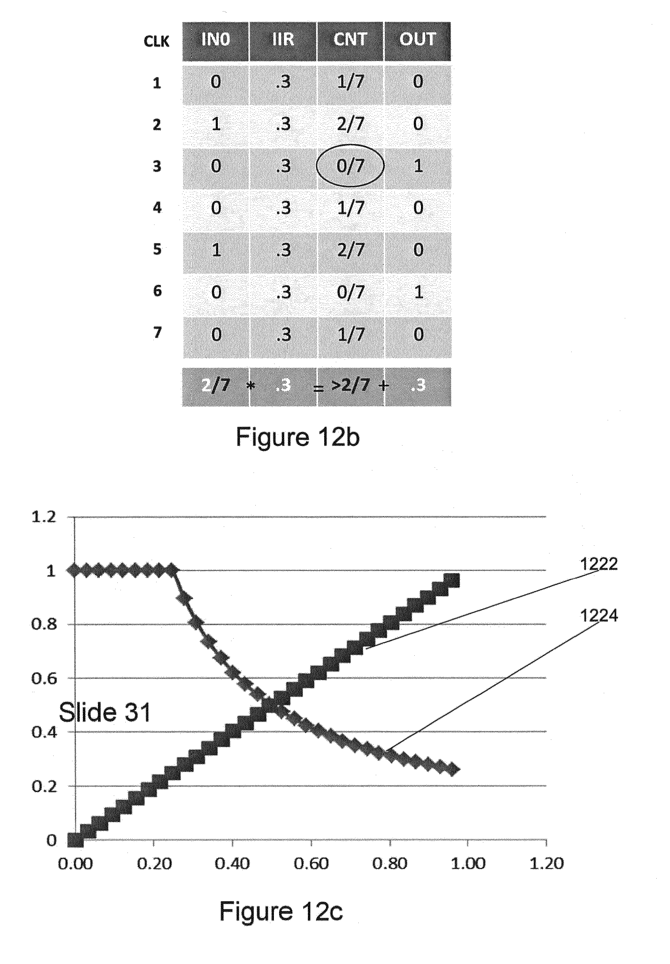

Figure 12b is a table illustrating an example series of logic states of the arithmetic unit of figure 12a. The table shows the value of the PDM input PDM_in, the output of the filter 1202, the count CNT of the counter 1208 and the PDM output signal PDM_out. The counter 1208 increments its count CNT each clock pulse. The counter 1208 reset when the PDM output signal PDM_out is at a logic level '1', as in the third and sixth cycles shown in the table.

Figure 12c illustrates a profile 1222 of an input value and a profile 1224 of corresponding reciprocal values determined by using the arithmetic unit 1200. The profiles are scaled between values of 0 and 1 on axes that correspond to signal magnitude and time/clock cycle, respectively.

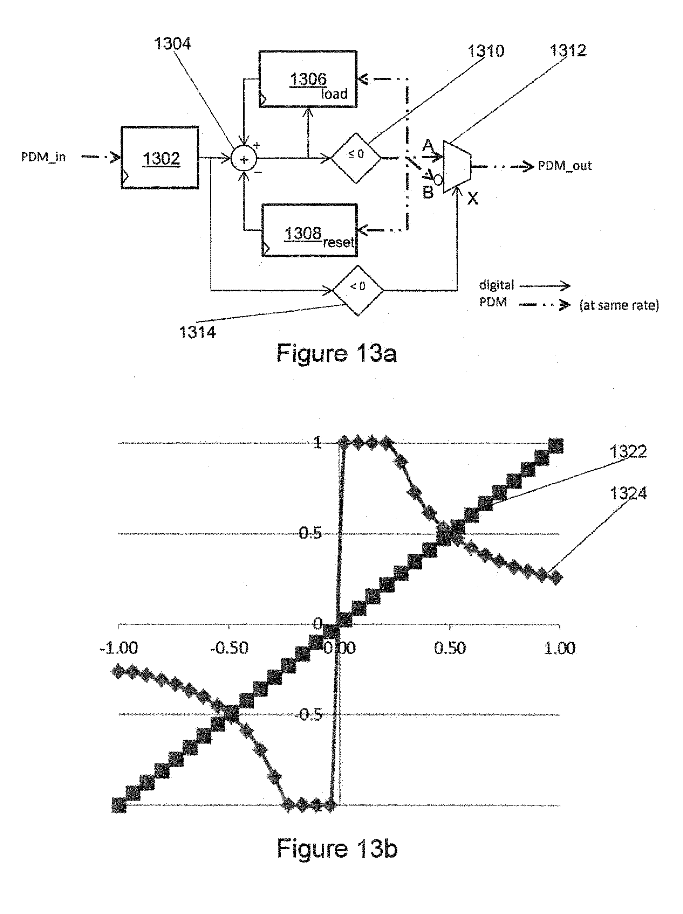

Figure 13a illustrates an arithmetic unit 1300 for dividing a signed PDM bit-stream (Reciprocal). The arithmetic unit 1300 comprises a filter 1302, an adder unit 1304, an error register 1306, a counter 1308 and a converter 1310, each of which are arranged in a similar manner to the corresponding components in the arithmetic unit of figure 12. In this case, these components are all configured to handle signed values. In addition, the arithmetic unit 1300 comprises a multiplexor 1312 and a modulus unit 1314.

The multiplexor 1312 has a first selectable input A and an inverting second selectable input B. Both the first and second selectable inputs A, B are configured to receive a PDM signal from the converter 1310. The multiplexor 1312 has a selecting input that is configured to receive an output of the modulus unit. The modulus unit 1314 is configured to receive the averaged value from the filter 1302. If the averaged value corresponds to a value greater than (or equal to) zero then the multiplexor 1312 provides the PDM signal at its first selectable input as a PDM output signal PDM_out. If the averaged value corresponds to a value less than zero then the multiplexor 1312 provides the inverted PDM signal at its second selectable input as the PDM output signal PDM_out. In this way, an approximation of a signed reciprocal function is provides, as illustrated in figure 13b.

Figure 13b illustrates a profile 1322 of an input value and a profile 1324 of corresponding reciprocal values determined by using the arithmetic unit 1300. The profiles are scaled between values of 0 and 1 on axes that correspond to magnitude and time/clock cycle.

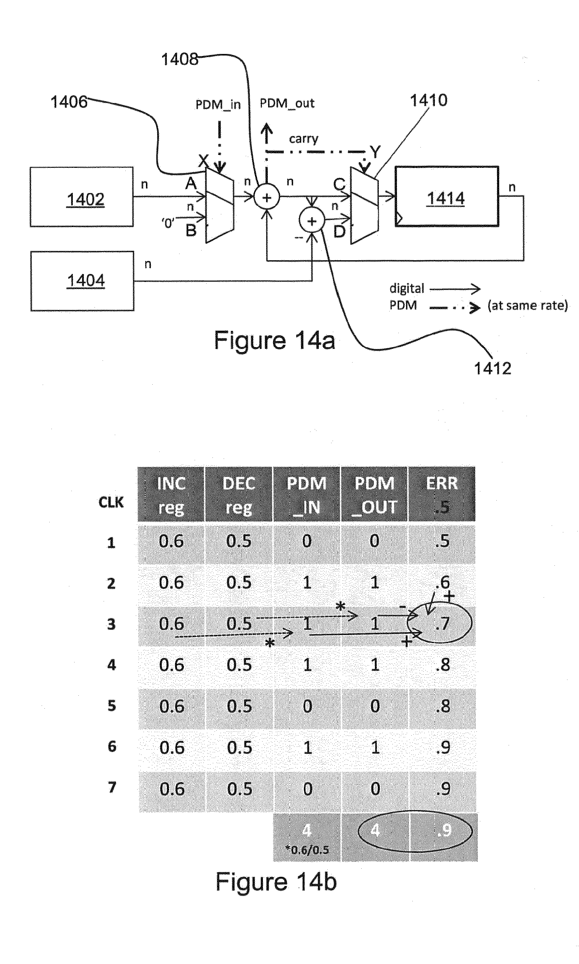

Figure 14a illustrates an arithmetic unit 1400 configured to scale an unsigned PDM input signal PDM_in using an increment value in an increment register 1402 and a decrement value in a decrement register 1404.

A first multiplexor 1406 has a first selectable input A configured to receive the increment value form the increment register 1402 and a second selectable input B with a logic level '0' input. The PDM input signal PDM_in is provided to a selecting input X of the multiplexor 1406. An output of the first multiplexor 1406 is provided as an input to a first adder unit 1408.

A second multiplexor 1410 has a first selectable input C coupled to a multi-bit output of the first adder unit 1408. The multi-bit output of the first adder unit 1408 is also provided as an input to a second adder unit 1412. A decrementing value from the decrementing register 1404 is provided as a decrementing input of the second adder unit 1412. A second selectable input D of the second multiplexor 1410 is coupled to a multi-bit output of the second adder unit 1412. A selecting input Y of the second multiplexor 1410 is provided with a PDM output signal PDM_out from the first adder unit 1408. An output of the second multiplexor 1410 is provided as an error signal ERR to an error register 1414, which is similar to that discussed with regard to figure 5a. The error signal is fed through the error register 1414 in a subsequent clock cycle and provided to a binary input of the first adder unit 1408.

Figure 14b is a table illustrating an example series of logic states of the arithmetic unit 1400. In this example, the decrementing register has a 0.5 value (and the incrementing register has an incrementing value of 0.6. The table illustrates the value of the increment register, the value of the decrement register, the PDM input signal PDM_in, PDM output signal PDM_out and the ERR signal at the input of the error register 1414. The dotted arrows in figure 14b illustrate quantities that are multiplied together to arrive at the PDM output and error signal values. For example, during the third clock cycle the incrementing value of 0.6 is multiplied by the PDM input signal value of logic level '1' and the decrementing value of 0.5 is multiplied by the PDM output signal value of logical level '1'. These two products are added to the signal ERR_Out of 0.6 from the error register 1414, which provides the error signal ERR from the previous clock cycle. The sum of these values gives a value of 0.9 for the error signal and producing a logic level '1' at the PDM output.

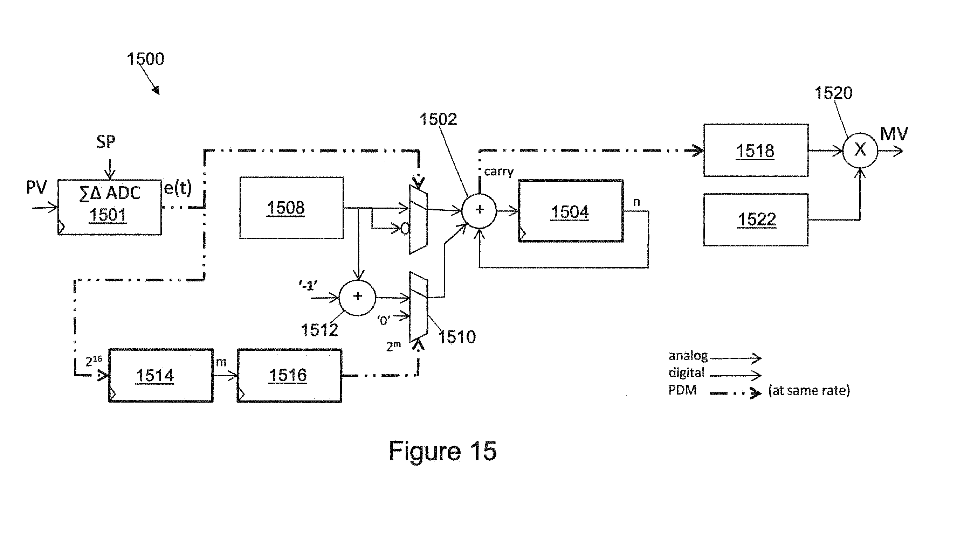

Figure 15 illustrates a system 1500 comprising an analogue-to-digital converter, an arithmetic unit configured to perform digital signal processing and a digital to analogue converter.

The analogue-to-digital converter comprises a sigma delta converter 1501 configured to receive an analog input signal SP and provide a pulse density modulated (PDM) signal e(t) in accordance with the input signal SP. The PDM signal e(t) is processed by the arithmetic unit and a PDM output signal is provided to the digital-to-analogue converter.

The digital-to-analogue converter comprises a low pass filter 1518 to convert the PDM output signal into an analogue signal. In this example, an analogue multiplication block 1520 multiplies the analogue signal by an analogue external parameter 1522.

The arithmetic unit is similar to that of figure 9a. In addition, a second multiplexor 1510 having a first selectable input, a second selectable input, a selecting input and an output is provided. The output of the second multiplexor 1510 is provided to an input of the adder unit 1502 (instead of the fixed value of 0.5 as in figure 9a). The first selectable input is coupled to the output of a second adder 1512, which adds -1 to the parameter from the parameter register 1508.

An integrator 1514 receives the PDM input signal e(t) and provides an integrated signal m to a PDM modulator 1516. The output of the PDM modulator 1516 is provided to the selecting input of the second multiplexor.

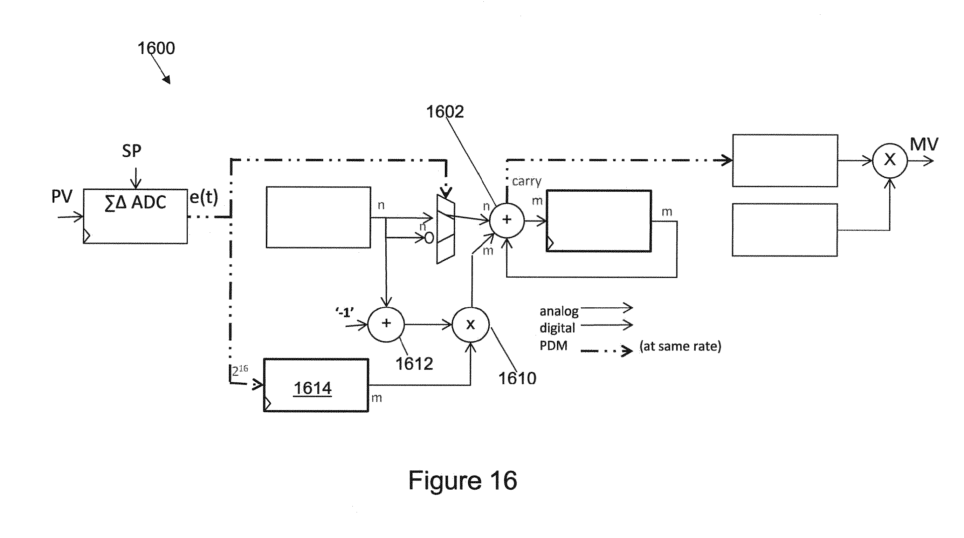

Figure 16 illustrates a system similar to that of figure 15. In this example the PDM modulator is omitted. The integrator 1614 provides the integrated signal m to a multiplier unit 1610, which is provided instead of the second multiplexor of figure 15. The multiplier unit 1610 also receives the output of the second adder unit 1612 and provides a multiplied binary signal to the respective input of the adder unit 1602.

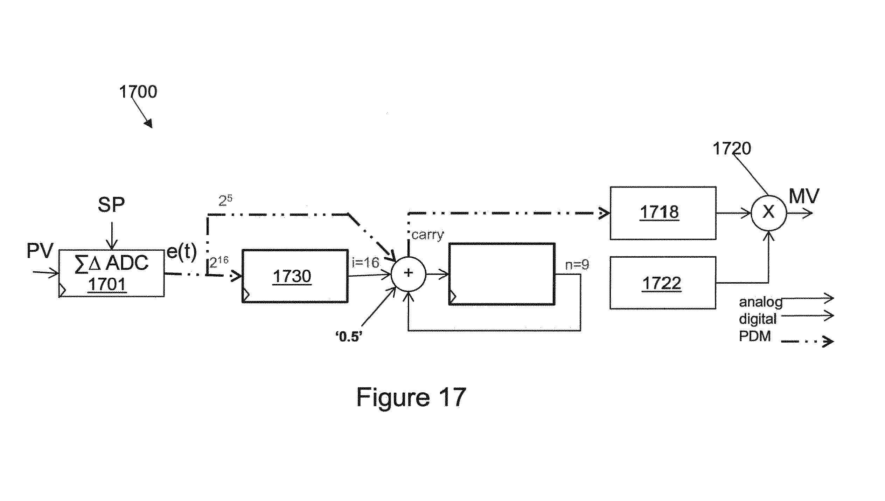

Figure 17 illustrates another system 1700 comprising an analogue-to-digital converter, an arithmetic unit to perform digital signal processing and a digital to analogue converter.

The analogue-to-digital converter comprises a sigma delta converter 1701 configured to receive an analog input signal SP and provide a pulse density modulated (PDM) signal e(t) in accordance with the input signal SP. The PDM signal e(t) is processed by the arithmetic unit and a PDM output signal is provided to the digital-to-analogue converter.

The digital-to-analogue converter comprises a low pass filter 1718 to convert the PDM output signal into an analogue signal. An analogue multiplication block 1720 multiplies the analogue signal by an analogue external parameter 1722.

In this example, the arithmetic unit is similar to that of figure 5a expect that an integrator 1730 is provided. The integrator 1730 is configured to receive the PDM signal e(t) and provide a multi-bit signal as an additional input to the adder unit 1702.

## Claims

1. A control system comprising:
one or more converters, each configured to receive an analog input signal and provide a pulse density modulated signal in accordance with the respective input signal, wherein the one or more converters are configured to operate at the same clock rate;
an arithmetic unit configured to perform an arithmetic function on the one or more pulse density modulated signals and provide a modified pulse density modulated signal; and
a control unit configured to receive the modified pulse density modulated signal and provide a control signal in accordance with the modified pulse density modulated signal.

2. The control system of claim 1, wherein the arithmetic unit is configured to perform an arithmetic function on the one or more pulse density modulated signals and one or more multi-bit values.

3. The control system of claim 2, wherein the one or more multi-bit values are stored in a parameter register.

4. The control system of claim 1, 2 or 3, wherein the arithmetic unit performs an unsigned addition and comprises:
an adder unit having a plurality of inputs, a carry bit output and a remainder output; and
a register configured to receive a remainder from the adder unit in a first clock cycle and provide the received remainder as one of the plurality of inputs to the adder unit in a subsequent clock cycle,
wherein the control unit is configured to provide the control signal in accordance with a pulse density modulated signal at the carry bit output of the adder unit.

5. The control system of claim 4, wherein the adder unit is configured to add together signals at the plurality of inputs and provide a signal at the carry bit output if the signals at the plurality of inputs are greater than a weighting value and provide a remainder signal at the remainder output that is equal to the sum of the added together signals at the plurality of inputs divided by the weighting value, minus a value of the signal at the carry bit output.

6. The control system of any of claims 4 or 5, wherein one or more of the inputs of the adder unit are configured to receive one or more respective pulse density modulated signals from the one or more converters.

7. The control system of claim 4 or 5, wherein the arithmetic unit comprises a multiplexor with a first selectable input, a second selectable input, a selecting input, and an output that is equal to a signal at one of the first and second selectable inputs dependent on a signal received at the selecting input, wherein one of the plurality of inputs of the adder unit is configured to receive the output of the multiplexor and wherein the selecting input of the multiplexor is configured to receive the one or more pulse density modulated signals from the one or more converters.

8. The control system of claim 7 when dependent on claim 3 wherein the parameter register is coupled to the first selectable input of the multiplexor.

9. The system of claim 7, wherein the arithmetic unit comprises:
an averager having an input and an output, the output coupled to the first selectable input of the multiplexor;
a plurality of converters, each configured to receive an input signal and provide a respective pulse density modulated signal, wherein a second of the plurality of converters is configured to provide a second pulse density modulated signal to the input of the averager.

10. The system of claim3, wherein the parameter register is configured to store signed or unsigned values and the adder unit is configured to add signed or unsigned values.

11. The system of claim 1, 2 or 3, wherein the arithmetic unit comprises:
an adder unit configured to receive a signal in accordance with a pulse density modulated signal from the one or more converters;
a counter configured to increment a count each clock cycle of the pulse density modulated signal and provide the count as an input to the adder unit and be reset in accordance with a pulse density modulated signal derived from an output of the adder unit; and
a register configured to receive a remainder from the adder unit in a first clock cycle and provide the received remainder as one of the plurality of inputs to the adder unit in a subsequent clock cycle.

12. The system of claim 1, 2 or 3, wherein the arithmetic unit comprises:
an averager configured to receive the pulse density modulated signal and provide an averaged signal;
a counter configured to increment a count each clock cycle of the pulse density modulated signal and provide the count as an input to the adder unit;
a comparison unit configured to compare the averaged pulse density modulated signal with the count and provide a modified pulse density modulated signal in accordance with the comparison,
wherein a reset for the counter is configured to receive the modified pulse density modulated signal from the comparison unit.

13. The system of claim 3, wherein the arithmetic unit comprises:
an increment register for storing an increment value;
a decrement register for storing a decrement value;
a first adder unit for providing a modified pulse density modulated;
a second adder unit, wherein the decrementing value from the decrementing register is provided as a decrementing input of the second adder unit;
a first multiplexor that has a first selectable input configured to receive the increment value form the increment register and a second selectable input with a logic level zero input, wherein the pulse density modulated signal is provided to a selecting input of the multiplexor and an output of the first multiplexor is provided as an input to a first adder unit;
a second multiplexor that has a first selectable input coupled to an output of the first adder unit and an input of the second adder unit, a second selectable input of the second multiplexor is coupled to an output of the second adder unit, a selecting input of the second multiplexor is provided with the pulse density modulated output signal from the first adder unit; and
a register configured to receive the output from the second multiplexor in a first clock cycle and provide the output of the second multiplexor as one of the plurality of inputs to the first adder unit in a subsequent clock cycle.

14. The system of claim 1 to 13, wherein the arithmetic unit is configured to perform a combination of signed and/or unsigned arithmetic functions to implement a proportional-integral control function of the control system.

15. A power supply converter comprising:
a primary side;
a secondary side;
a transformer configured to transfer energy from the primary side to the secondary side; and
the control system of any preceding claim, wherein the control unit is configured to control a supply of energy to the transformer.
